# EUROPEAN PATENT SPECIFICATION

(11) **EP 1 505 685 B1**
(45) Date of publication and mention of the grant of the patent: **18.04.2007**
(21) Application number: 03017095.5
(22) Date of filing: 28.07.2003
(51) Int. Cl.: H01P 3/08, H01P 11/00

(54) **Microstrip line and method for producing of a microstrip line**
Mikrostreifenleitung und Verfahren für ihre Herstellung
Ligne microruban et procedé pour fabriquer une ligne microruban

(43) Date of publication of application: 09.02.2005
(73) Proprietor: Qimonda AG, 81739 München (DE)
(72) Inventor: Kuzmenka, Maksim, 81829 München (DE)
(74) Representative: Schoppe, Fritz

(56) References cited:
- US-A- 5 724 012
- PATENT ABSTRACTS OF JAPAN vol. 014, no. 550 (E-1009), 6 December 1990 (1990-12-06) -& JP 02 235406 A (A T R HIKARI DENPA TSUSHIN KENKYUSHO:KK), 18 September 1990 (1990-09-18)
- PATENT ABSTRACTS OF JAPAN vol. 015, no. 062 (E-1033), 14 February 1991 (1991-02-14) & JP 02 288403 A (NEC CORP), 28 November 1990 (1990-11-28)
- PATENT ABSTRACTS OF JAPAN vol. 018, no. 340 (E-1569), 27 June 1994 (1994-06-27) -& JP 06 085510 A (YOKOGAWA ELECTRIC CORP), 25 March 1994 (1994-03-25)

## Description

The present invention relates to a microstrip line and, in particular, to a microstrip line comprising a dielectric with a low dielectric constant and a method for producing the same.

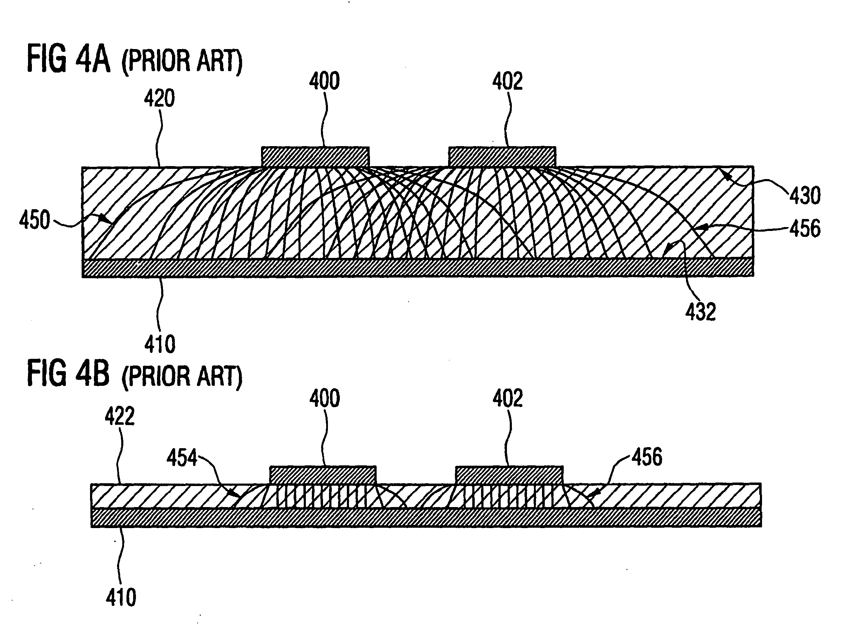

A cross section view of a conventional structure of microstrip lines is illustrated in Fig. 4a and 4b. Fig. 4a shows a printed circuit board as it is used for high frequency applications, on which a plurality of signal lines are running in parallel. The printed circuit board comprises two signal lines 400, 402, a ground layer 410 and a dielectric 420. The dielectric 420 comprises a first surface 430 and a second surface 432. The signal lines 400, 402, are arranged on the first surface 430 of the dielectric 420 and the ground layer 410 is arranged on the second surface 432. Each of the signal lines 400, 402 represent a microstrip line together with the dielectric 420 and the ground layer 410. In high-frequency applications an electro-magnetic field exists between the signal lines 400, 402 and between the signal lines 400, 402 and the ground layer 410. The field is indicated by a plurality of electrical field lines 450, 452. The density of the lines 450, 452 indicates a strength of the electrical field. As can be seen from Fig. 4a, the electrical field lines 450 belonging to the first signal line 400 cross the electrical field lines 452 belonging to the second signal line 402. The resulting cross-talk between the neighboring signal lines 400, 402 makes the signal quality worse and the signal to noise factor decreases. A magnetic coupling between the signal lines 400, 402 does not effect the cross talk as long as the magnetic permittivity of the dielectric is 1.

One possible solution to prevent cross-talk between neighboring signal lines is to increase the spacing between the lines. Another solution is to add additional ground traces between the neighboring signal lines 400, 402. But, due to the routing density in many designs, like memory modules, these prior art solutions are problematic.

Another solution to prevent or reduce cross-talk between neighboring traces is shown in Fig. 4b. Fig. 4b shows the two signal lines 400, 402 and the ground layer 410 as shown in Fig. 4a. The arrangement of Fig. 4b shows a dielectric 422 which is arranged between the signal lines 400, 402 and the ground layer 410. The dielectric 422 of Fig. 4b is thinner than the dielectric 420 of Fig. 4a. Thus, the spacing between the signal lines 400, 402 and the ground layer 410 is reduced in this embodiment. Electrical field lines 454, 456 between the signal lines 400, 402 and the ground layer 410 concentrate mostly in the space between the corresponding signal line 400, 402 and the ground layer 410. The electrical field lines 454 of the first signal line 400 do not affect the second signal line 402. The same is true for the electrical field lines 456 which do not affect the signal line 400.

The embodiment shown in Fig. 4b solves the problem of cross-talk but has the disadvantage that a reduction of the space between the signal lines 400, 402 and the ground layer 410 effects the trace impedance of the arrangement. In order to adapt the trace impedance of the embodiment shown in Fig. 4b to the embodiment shown in Fig. 4a, the dielectric constant of the thin dielectric 422 has to be lower than the dielectric constant of the wide dielectric 420. The dielectric 422 of the embodiment shown in Fig. 4b should comprise a dielectric constant lower than 3. According to the prior art, such suitable materials with dielectric constants lower than 3 do not exist.

JP 02 235406 A discloses a microwave line. The microwave line comprises a center conductor, a conductor and a dielectric film. The dielectric film is arranged between the center conductor and the conductor. The dielectric film is removed in regions between the conductors. The regions have a low dielectric constant. The dielectric film in the regions is removed by etching.

JP 02 288403 A discloses a microstrip line and a method for producing the microstrip line. The microstrip line comprises a microstrip conductor and an earth conductor. Further, the microstrip line comprises insulator supports. The supports are surrounded by air. Therefore, a dielectric used for the microstrip line is mainly air and the dielectric loss can be made extremely small. For producing the microstrip line the microstrip conductor and the earth conductor is provided. A substrate is arranged between the microstrip conductor and the earth conductor. The substrate is removed afterwards and leaves the microstrip line.

US 5,724,012 A describes a microstrip line comprising a conductive base and a conductor structure. A dielectric sheet is arranged between the conductor structure and the conductive base. Below the conductor structure, the dielectric sheet comprises a cavity such that support for the conductor structure by the dielectric sheet is reduced to the edges of the conductor structure. The cavity is filled with air or a cooling fluid.

GB 1128010 discloses a transmission line comprising a center strip conductor and a ground panel. The transmission strip is arranged on a panel. Between the ground panel and the panel a honeycomb material is arranged. The honeycomb material is arranged beside the transmission strip.

JP 62194703 shows a microstrip circuit comprising a printed circuit board, being clipped by two ground conductor plates via dielectrics. The surrounding of the board between the ground conductor plates is surrounded by a short-circuit plate comprising a metallic honeycomb.

It is the object of the present invention to provide a method for producing of a microstrip line providing a high signal quality and an improved signal to noise factor and.

This object is achieved by a method for producing of a microstrip line according to claim 1.

The present invention provides a method for producing of a microstrip line comprising the steps of:
a) Providing a substrate comprising material for supporting and material for removing;
b) providing a conductive trace and a ground conductor, so that the conductive trace is arranged on a first surface and the ground conductor on a second surface of the board substrate and the material for supporting and the material for removing is arranged between the conductive trace and the ground conductor; and
c) removing the material for removing.

The present invention is based on the finding that a two-component dielectric which comprises two materials with different dielectric constants, allows to produce a two-component dielectric comprising an effective dielectric constant less than the dielectric constant of conventional dielectrics.

According to the inventive arrangement, the two-component dielectric comprises a first dielectric material with a first dielectric constant. Regions of the two-component dielectric which do not comprise the first material are occupied with a second dielectric material which comprises a dielectric constant that is lower than the dielectric constant of the first material. The first material is primarily used for supporting the arrangement. Therefore, the second material can be any material which provides a low dielectric constant. If the first material is a dielectric according to the prior art then an effective dielectric constant of the two-component dielectric lower than three can be achieved.

The present invention allows for an improved signal quality on signal lines of a printed circuit board for high-frequency applications compared to conventional solutions, making use of a special arrangement of two dielectric materials between a signal line and a ground layer of the printed circuit board. This provides a reduced effective dielectric constant which can be advantageously used to reduce the spacing between signal lines and a ground layer without changing the characteristic impedance of a microstrip arrangement. Thus, cross-talk between neighboring signal lines is reduced and the signal quality is improved. Furthermore, the routing density is retained and a propagation delay on the signal lines is reduced, as the propagation delay is approximately proportional to the square root of the dielectric constant.

Preferred embodiments of the present invention are described hereinafter, making reference to the appended drawings.
- Fig. 1a and 1b: show a schematic view of a microstrip line embodying the present invention and a method for producing of the same;
- Fig. 2a to 2c: show a schematic view of a microstrip line according to another embodiment of the present invention and a method for producing of the same;
- Fig. 3a to 3d: show a schematic view of a microstrip line according to a further embodiment of the present invention and a method for producing of the same; and
- Fig. 4a and 4b: show a schematic view of two microstrip lines according to the prior art.

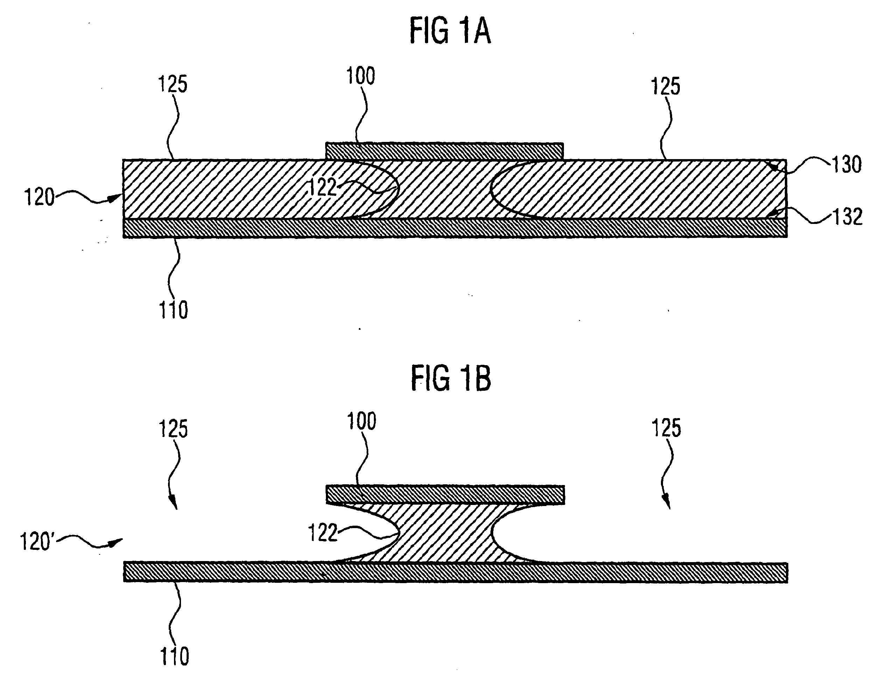

Fig. 1a and 1b show a schematic view of a microstrip line according to the present invention and illustrate a method for producing the same.

Fig. 1a shows an arrangement which can be used for producing of a microstrip line according to the present invention. The arrangement comprises a signal line 100 and a ground layer 110. The signal line 100 represents a signal trace. The signal line 100 and the ground layer 110 are preferably made of copper. Between the signal line 100 and the ground layer 110 a dielectric substrate 120 is arranged. The dielectric 120 comprises material for supporting arranged in a first region 122 and material for removing arranged in second regions 125. In this embodiment the material used for the material for supporting arranged in the first region 122 is the same as the material used for the material for removing arranged in the second region 125. The dielectric 120 comprises a first surface 130 and a second surface 132. The signal line 100 is arranged on the first surface 130 and the ground layer 110 is arranged on the second surface 132. The second region 125 comprising the material for removing extends under the signal line 100.

In a following step of the method for producing the microstrip line, the material for removing arranged in the second regions 125 is removed. The removal of the material for removing in the second region 125 is done by way of chemical or ion etching.

Fig. 1b shows an embodiment of the microstrip line according to the present invention. After the removal of the material for removing the second regions 125 are filled by air. The signal line 100 is connected to the ground layer 110 by the material for supporting which is arranged in the first region 122. Thus, a new two-component dielectric 120' is formed by a first region 122 comprising the material for supporting with a first dielectric constant and second regions 125 comprising air. The dielectric constant of air is very low. Thus, the efective dielectric constant of the two-component dielectric 120' is lower than the dielectric constant of the dielectric 120 in Fig. 1a.

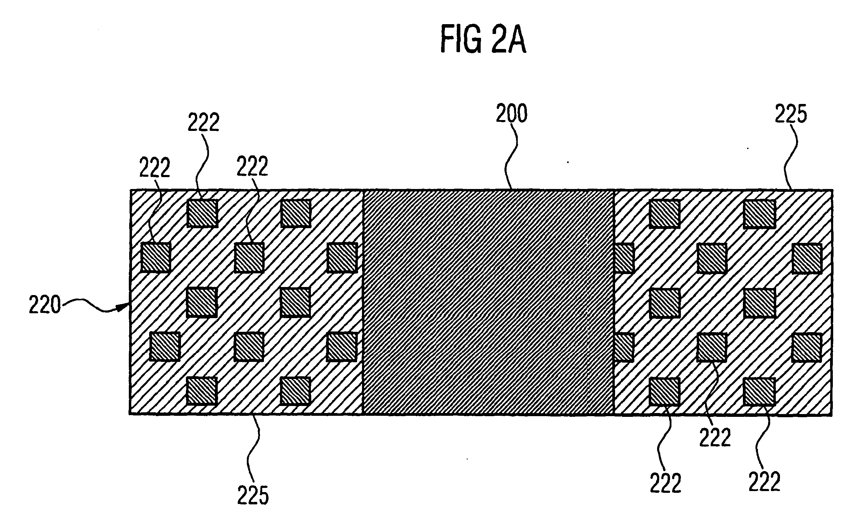

A further embodiment of a microstrip line according to the present invention and a method for producing of the same is shown in Fig. 2a to 2c.

Fig. 2a shows a schematic top view of an arrangement which can be used for producing of a microstrip line according to another embodiment of the present invention. The arrangement comprises a signal line 200 which is arranged on a substrate 220. The substrate 220 comprises a plurality of first regions 222 and a second region 225. The first regions 222 comprise a main dielectric which represents a material for supporting. The second region comprises an auxiliary dielectric which represents a material for removing. As can be seen from Fig. 2a, the first regions 222 are arranged within the second region 225 in a kind of "chess order".

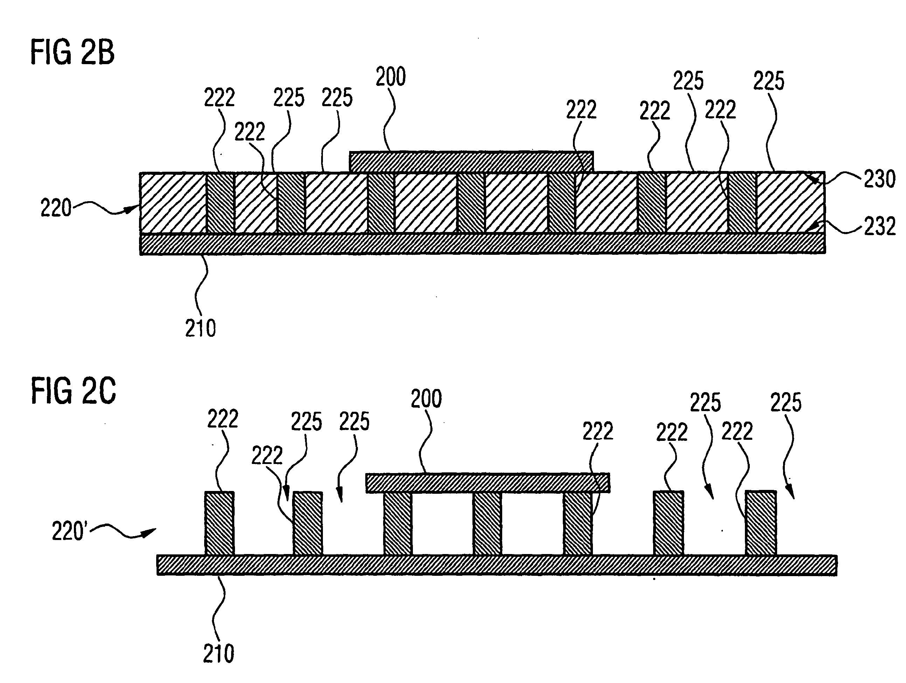

Fig. 2b shows the arrangement of Fig. 2a in a schematic side view. The signal line 200 is arranged on a first surface 230 of the substrate 220 and a ground layer 210 is arranged on a second surface 232 of the substrate 220. As can be seen from Fig. 2b, the regions 222 form a plurality of posts which extend from the first surface 230 to the second surface 232 of the substrate 220.

The signal line 200 and the ground layer 210 can be arranged on the substrate 220 in a manner known to a man of ordinary skills. In a next step of the method for producing, the material for removing which is arranged in the second region 225 is removed. In this embodiment the removal of the material for removing is done by way of chemical etching.

The arrangement of the microstrip line shown in Fig. 2b after the step of removing the material for removing, is shown in Fig. 2c, in a schematic view. The arrangement is now forming a microstrip line according to a further embodiment of the present invention. The microstrip line comprises the signal line 200, the ground layer 210 and a plurality of posts formed in the first regions 222 which comprise material for supporting. The second regions 225 are now occupied by air. The signal line 200 is supported by a plurality of posts which are arranged under the signal line 200. To be more specific, Fig. 2c shows three posts 222 which support the signal line 200. Thus, the arrangement and dimension of the first regions 222 which form the posts are selected such that an appropriate number of points of support is supplied.

In a preferred embodiment, the first regions 222 comprise PCB FR-4 material as a material for supporting. PCB FR-4 material is a standard dielectric and comprises a dielectric constant of 4. In this embodiment, the first regions 222 occupy half of the space between the signal line 200 and the ground layer 210. Thus, the effective dielectric constant of the two-component dielectric 220' between the signal line 200 and the ground layer 210 is approximately 2.

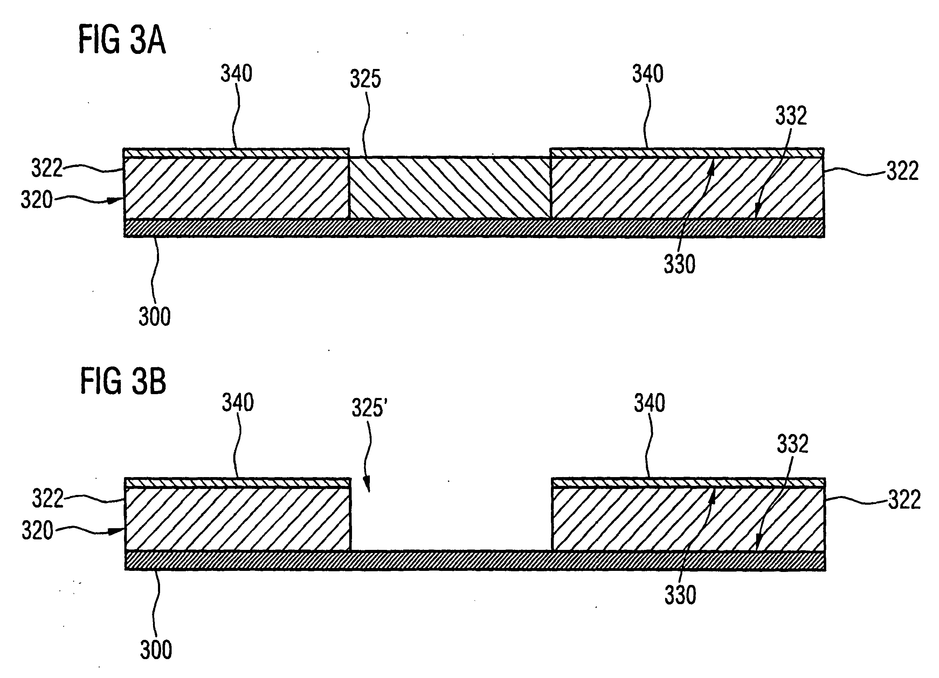

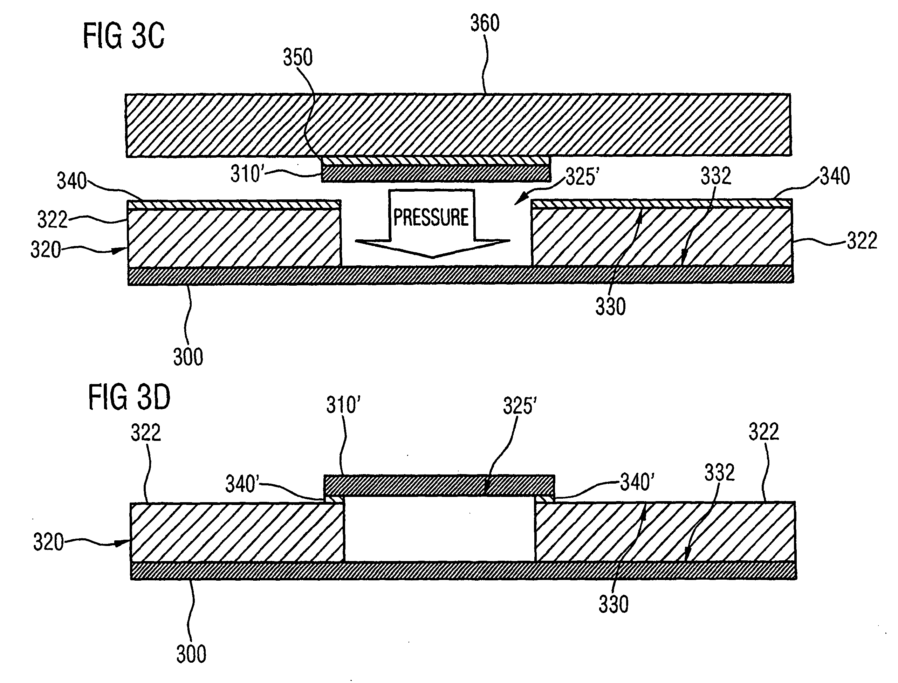

Fig. 3a to 3d show a further embodiment of a microstrip line and a method for producing of the same.

Fig. 3a shows a schematic top view of an arrangement which can be used for producing of a microstrip line according to a further embodiment of the present invention. The arrangement comprises a first electrical conductor 300 and a substrate 320. The substrate 320 comprises two first regions 322 and a second region 325. The substrate 320 comprises a first surface 330 and a second surface 332. A photoresist 340 which additionally serves as a glue is arranged on the first surface 330 of the first regions 322 of the substrate 320. The first electrical conductor 300 is arranged on the second surface 332 of the substrate 320.

The method for producing of the microstrip line comprises steps of providing the substrate 320 and arranging of the first conductor 300 on the second surface 332 of the substrate 320. The arrangement of the fist electrical conductor 300 on the substrate 320 can be implemented in a manner known to a man of ordinary skills.

In a following step a trench 325' is formed into the substrate 320 by way of etching the material of the substrate 320 which is arranged in the second region 325. The second region 325 is not covered by the photoresist 340. Fig. 3b shows the trench 325' which extends from the first surface 330 to the second surface 332 of the substrate 320. The trench 325' is occupied by air.

Fig. 3c shows a following step of providing a second conductor 310' and arranging of the same on the first surface 330 of the substrate 320 such that the trench 325' is arranged between the first conductor 300 and the second conductor 310'. The second conductor 310' covers the trench 325'.

For producing, the second conductor 310' is fixed with glue 350 to a second substrate 360 which is removed in a later step. By pressing the second substrate 360 against the substrate 320, the second conductor 310' is fixed to the first surface 330 of the substrate 320. Additionally, the arrangement can be heated to achieve a reliable connection between the conductor 310' and the substrate 320.

Fig. 3d shows the microstrip line after removing of the auxiliary second substrate 360, the glue 350 and auxiliary parts of the glue 340. The second conductor 310' is fixed on the first surface 330 of the first regions 322 of the substrate 320 by the glue 340' the dimensions of the glue 340' are not shown in correct scale. Most of the space between the second conductor 310' and the first conductor 300 is occupied by air or a vacuum. Thus, the effective dielectric constant of the dielectric between the first conductor 300 and the second conductor 310' is small compared to solutions of the prior art.

Also the present invention has been described above, making reference to a microstrip line comprising two different dielectric materials, wherein one dielectric material is air, it is clear that the present invention can also comprise microstrip lines which comprise more than two dielectric materials and use dielectric materials other than air. Moreover, the arrangements and dimensions of the different materials are not limited to the embodiments shown above, but may have any arrangement or dimension which is advantageous for the application the microstrip line is used for and the method for producing of the same. The removing of material is not limited to etching but can be done in any other way. In Fig. 3, the trench might extend only partly from the first surface into the substrate. In this case, the trench can be formed prior to arranging the first electrical conductor on the substrate. Instead of using a glue to fix the second conductor on the substrate, the second conductor can be fixed on the substrate just by pressing the second conductor against the first surface of the substrate.

### List of reference numbers

- 100: signal lines
- 110: ground layer
- 120: dielectric
- 122: first region.
- 125: second regions
- 130: first surface of substrate
- 132: second surface of the substrate 120' dielectric
- 200: signal line
- 210: ground layer
- 220: dielectric
- 222: first regions
- 225: second regions
- 230: first surface of the dielectric
- 232: second surface of the dielectric
- 220': dielectric
- 300: first electrical conductor
- 320: substrate
- 322: first region
- 325: second region
- 325': trench
- 330: first surface of the substrate
- 332: second surface of the substrate
- 340: photoresist/loop
- 310': second electrical conductor
- 350: loop
- 360: second substrate
- 340': photoresist/loop
- 400: first signal line
- 402: second signal line
- 410: ground layer
- 420: dielectric
- 430: first surface of the dielectric
- 432: second surface of the dielectric
- 450, 452: electrical field lines
- 454, 456: electrical field lines

## Claims

1. Method for producing of a microstrip line comprising the steps of:
a) Providing a substrate (220) comprising material for supporting (222) and material for removing, wherein the material for supporting is arranged in a plurality of posts (222) being arranged within the material for removing; wherein the posts extend from a first surface (230) to a second surface (232) of the board substrate (220);
b) providing a conductive trace (200) and a ground conductor (210), so that the conductive trace is arranged on the first surface (230) and the ground conductor on the second surface (232) of the substrate and wherein a number of posts (222) are arranged between the conductive trace and the ground conductor, and wherein posts (222) are arranged on the ground conductor beside the conductive trace, and wherein the material for removing extends between the conductive trace and the ground conductor; and
c) removing the material for removing.

2. Method for producing of a microstrip line according to claim 1, wherein the removing of the material for removing in step b) is done by way of etching.

## Patentansprüche

1. Verfahren zum Herstellen einer Mikrostreifenleitung, das folgende Schritte aufweist:
a) Bereitstellen eines Substrats (220), das ein Material zum Tragen (222) und ein Material zum Entfernen aufweist, wobei das Material zum Tragen in einer Mehrzahl von Stützen (222) angeordnet ist, die innerhalb des Materials zum Entfernen angeordnet sind; wobei sich die Stützen von einer ersten Oberfläche (230) zu einer zweiten Oberfläche (232) des Platinensubstrats (220) erstrecken;
b) Bereitstellen einer Leiterbahn (200) und eines Masseleiters (210), so dass die Leiterbahn auf der ersten Oberfläche (230) und der Masseleiter auf einer zweiten Oberfläche (232) des Substrats angeordnet ist, und wobei eine Anzahl von Stützen (222) zwischen der Leiterbahn und dem Masseleiter angeordnet ist, und wobei Stützen (222) auf dem Masseleiter neben der Leiterbahn angeordnet sind, und wobei das Material zum Entfernen sich zwischen der Leiterbahn und dem Masseleiter erstreckt; und
c) Entfernen des Materials zum Entfernen.

2. Verfahren zum Herstellen einer Mikrostreifenleitung gemäß Anspruch 1, bei dem das Entfernen des Materials zum Entfernen bei Schritt b) mittels Ätzen durchgeführt wird.

## Revendications

1. Procédé pour fabriquer une ligne microruban, comprenant les étapes consistant à :
a) préparer un substrat (220) comprenant un matériau de support (222) et un matériau à enlever, dans lequel le matériau de support est disposé dans une pluralité de montants (222) disposés dans le matériau à enlever ; dans lequel les montants s'étendent d'une première surface (230) à une deuxième surface (232) du substrat de plaquette (220) ;
b) préparer une trace conductrice (200) et un conducteur de terre (210), de sorte que la trace conductrice soit disposée sur la première surface (230) et le conducteur de terre sur la deuxième surface (232) du substrat, et dans lequel un certain nombre de montants (222) soient disposés entre la trace conductrice et le conducteur de terre, et dans lequel les montants (222) sont disposés sur le conducteur de terre à côté de la trace conductrice, et dans lequel le matériau à enlever s'étend entre la trace conductrice et le conducteur de terre ; et
c) enlever le matériau à enlever.

2. Procédé pour fabriquer une ligne microruban selon la revendication 1, dans lequel l'enlèvement du matériau à enlever à l'étape b) s'effectue par gravure.
